# FASCICULE DE BREVET EUROPEEN

(11) **EP 2 586 741 B1**
(45) Date de publication et mention de la délivrance du brevet: **23.03.2016**
(21) Numéro de dépôt: 12189454.7
(22) Date de dépôt: 22.10.2012
(51) Int. Cl.: B81C 1/00, H01L 23/26

(54) **Structure d'encapsulation hermétique d'un dispositif et d'un composant électronique**
Hermetisch verschlossene Einkapselungsstruktur einer Vorrichtung und einer elektronischen Komponente
Structure for airtight encapsulation of a device and an electronic component

(30) Priorité: 28.10.2011 FR 1159848
(43) Date de publication de la demande: 01.05.2013
(73) Titulaire: Commissariat à l'Énergie Atomique et aux Énergies Alternatives, 75015 Paris (FR)
(72) Inventeur: Baillin, Xavier, 38920 CROLLES (FR); Pornin, Jean-Louis, 38920 CROLLES (FR)
(74) Mandataire: Ilgart, Jean-Christophe

(56) Documents cités:
- WO-A1-2011/003908
- FR-A1- 2 922 202
- US-A1- 2010 003 789
- US-A1- 2011 030 989
- US-A1- 2011 079 425
- US-A1- 2011 079 889

## Description

### DOMAINE TECHNIQUE

L'invention concerne une structure d'encapsulation comprenant une cavité hermétique dans laquelle sont encapsulés un dispositif, par exemple un microsystème ou un microcomposant notamment de type MEMS (microsystème électromécanique), NEMS (nano-système électromécanique), MOEMS (microsystème opto-électro-mécanique), NOEMS (nanosystème opto-électro-mécanique) ou un micro-détecteur infrarouge, ou plus généralement tout dispositif destiné à être encapsulé sous atmosphère contrôlée, avec un ou plusieurs composants électroniques, formant par exemple un circuit intégré, et un matériau getter.

L'invention concerne également un procédé d'encapsulation d'au moins un dispositif permettant de réaliser une telle structure d'encapsulation.

### ÉTAT DE LA TECHNIQUE ANTÉRIEURE

Certains dispositifs, tels que ceux de type MEMS, NEMS, MOEMS, NOEMS ou des micro-détecteurs infrarouge, nécessitent pour leur bon fonctionnement d'être enfermés, ou encapsulés, de manière hermétique dans une cavité dont l'atmosphère est contrôlée (contrôle notamment de la nature du gaz et de la pression régnant dans la cavité).

Une telle encapsulation peut être réalisée de manière collective pour plusieurs dispositifs réalisés sur un même substrat (ou wafer), appelé premier substrat. Chacun des dispositifs est alors encapsulé dans une cavité formée par report et scellement hermétique d'un capot, par exemple formé par un deuxième substrat de silicium ou de verre, sur le premier substrat. Cet assemblage hermétique entre le premier substrat et le deuxième substrat, formant de manière collective les cavités d'encapsulation des dispositifs, permet de protéger l'atmosphère régnant dans les cavités en empêchant les fuites de gaz entre l'intérieur des cavités et l'environnement extérieur.

En variante, les cavités peuvent être formées par une encapsulation de type TFP (« Thin Film Packaging »), ou PCM (Packaging Couche Mince), les capots étant dans ce cas formés d'une ou plusieurs couches minces superposées.

L'ajout de getters non évaporables (NEG) dans les cavités, par exemple sous la forme de portions de matériau getter disposées dans ces cavités, permet de contrôler les caractéristiques de l'atmosphère au sein des cavités. Les portions de matériau getter peuvent être réalisées à partir d'un dépôt en couche mince du matériau getter sur l'un ou l'autre des deux substrats, préalablement à l'opération d'assemblage entre les deux substrats. Une mise en forme des portions de matériau getter dans le plan de la surface du substrat sur laquelle le matériau getter est déposé est ensuite réalisée en mettant en oeuvre des opérations technologiques de photolithographie et de gravure de la couche mince de matériau getter. Dans le cas d'une encapsulation par couches minces, le matériau getter peut être réalisé sous la forme d'une couche mince correspondant à la première couche de l'empilement formant le capot, formant ainsi la paroi du capot se trouvant dans la cavité.

En variante, il est possible de déposer le matériau getter de manière discrète, directement sous la forme souhaitée. Pour cela, le matériau getter peut être déposé directement sur l'un ou l'autre des deux substrats par lift-off, à travers un film de résine photosensible préalablement mis en forme par photolithographie, ce film étant retiré après le dépôt du matériau getter à travers celui-ci.

Les dispositifs coopèrent généralement avec des composants électroniques, tels que des transistors MOS, faisant partie d'un circuit intégré. Afin d'améliorer la compacité et les performances, et réduire les coûts de réalisation de la structure composée du ou des dispositifs et du circuit intégré, il est envisagé d'intégrer les composants électroniques et les dispositifs sur un même substrat, en réalisant par exemple les dispositifs directement sur le ou les circuits intégrés.

Une telle intégration pose toutefois des problèmes pour le fonctionnement du ou des dispositifs.

En effet, les composants électroniques sont réalisés en mettant en oeuvre des dépôts sous vide de différents matériaux à partir de précurseurs gazeux, suivis d'opérations de photolithographie et gravure.

Ces dépôts peuvent être de type PVD (dépôt physique en phase vapeur), et comportent dans ce cas la mise en oeuvre d'une pulvérisation cathodique assistée par un gaz rare tel que de l'argon ou du krypton. Une partie du gaz rare utilisé se retrouve alors piégée dans le matériau déposé et est susceptible d'être relâchée si le ou les composants électroniques subissent une augmentation de température. Ainsi, si un ou plusieurs composants électroniques se retrouvent encapsulés avec un dispositif dans une même cavité, le gaz rare piégé serait alors relâché dans la cavité lors de l'activation thermique du matériau getter également présent dans la cavité, cette activation thermique ne pouvant être réalisée qu'une fois la cavité fermée. Or, les gaz rares ne peuvent pas être pompés par la ou les portions de matériau getter présentes dans la cavité.

Ce relâchement de gaz empêche donc de contrôler la pression et la nature de l'atmosphère régnant dans la cavité, le dispositif ne pouvant donc pas fonctionner correctement dans ce cas.

De même, les dépôts d'isolants tels que les oxydes ou nitrures de semi-conducteur, obtenus par CVD (dépôt chimique en phase vapeur) et mis en oeuvre lors de la réalisation des composants électroniques, mettent en jeu des précurseurs gazeux tels que le silane (SiH₄) dont la décomposition, lors du dépôt CVD, conduit à la formation d'hydrogène dont une partie peut se retrouver piégée dans la couche déposée. Si un composant électronique comportant un tel isolant se retrouvait encapsulé avec un dispositif dans une même cavité, l'hydrogène piégé traverserait le composant électronique et serait relâché dans la cavité lors de l'activation thermique du matériau getter présent dans la cavité. L'hydrogène serait alors pompé par la ou les portions de matériau getter présentes dans la cavité.

Etant donné que ces portions de matériau getter sont prévues pour atteindre un niveau de vide requis pour que le dispositif fonctionne correctement (par exemple un vide primaire proche de 10⁻³ mbar pour des dispositifs comportant des structures résonantes, par exemple des accéléromètres ou des gyromètres, ou de type détecteurs infrarouge non refroidis tels que des micro-bolomètres) et que l'activation de ce getter ne peut être réalisée qu'une fois la cavité fermée en chauffant l'ensemble de la cavité ainsi que les éléments présents dans la cavité, les gaz relâchés limitent donc fortement le niveau de vide pouvant être atteint dans la cavité, voire peuvent conduire à la saturation en gaz du matériau getter.

Le document US 2011/079889 A1 décrit une structure d'encapsulation comportant une cavité fermée hermétiquement. Des portions de matériau getter sont présentes dans la cavité.

### EXPOSÉ DE L'INVENTION

Un but de la présente invention est de proposer une solution pour encapsuler hermétiquement, dans une même cavité, au moins un dispositif avec au moins un composant électronique, et permettant d'éviter qu'un éventuel dégazage par un ou plusieurs matériaux du composant électronique ne perturbe le fonctionnement du dispositif.

Pour cela, la présente invention propose une structure d'encapsulation comportant au moins une cavité fermée hermétiquement dans laquelle sont encapsulés au moins :
- un dispositif,
- un composant électronique réalisé sur un premier substrat, et
- une couche de matériau getter recouvrant le composant électronique.

Ainsi, la couche de matériau getter recouvrant le composant électronique exposé dans la cavité permet de piéger et/ou bloquer les gaz susceptibles d'être dégazés par le composant électronique dans la cavité, par exemple suite à une activation thermique du matériau getter.

La couche de matériau getter recouvre le composant électronique de façon à bloquer les gaz (ou espèces gazeuses) susceptibles d'être dégazés, ou émises, par le composant électronique.

Le dispositif n'est pas recouvert par la couche de matériau getter.

Etant donné que le dispositif et le composant électronique sont disposés dans une même cavité, une telle structure d'encapsulation peut donc être réalisée avec une meilleure compacité, et donc avec un coût de réalisation réduit. De plus, étant donné que les gaz piégés dans le composant électronique ne sont pas relâchés dans la cavité grâce à la couche de matériau getter, les performances du dispositif ne sont pas dégradées.

De plus, la face de la couche de matériau getter qui est disposée du côté du circuit intégré n'est pas exposée aux traitements subis par la couche de matériau getter, notamment une éventuelle mise en forme par photolithographie et gravure, puisque ces traitement se font au niveau de la face opposée à celle se trouvant du côté du composant électronique et par laquelle l'absorption gazeuse est destinée à être réalisée.

Une telle structure d'encapsulation est avantageusement utilisée pour réaliser une encapsulation collective de dispositifs en vue d'un packaging sous atmosphère contrôlée dans chaque cavité.

L'invention concerne aussi une structure d'encapsulation comportant au moins une cavité fermée hermétiquement dans laquelle sont encapsulés au moins :
- un dispositif,
- un composant électronique réalisé sur un premier substrat et comprenant au moins un matériau obtenu soit par la mise en oeuvre d'un dépôt par voie chimique à partir de précurseurs gazeux, par exemple un dépôt CVD (dépôt chimique en phase vapeur), soit par la mise en oeuvre d'un dépôt par voie physique, par exemple une pulvérisation cathodique, et
- une couche de matériau getter recouvrant le composant électronique.

L'invention concerne également une structure d'encapsulation comportant au moins une cavité fermée hermétiquement dans laquelle sont encapsulés au moins :
- un dispositif,
- un composant électronique réalisé sur un premier substrat et comprenant au moins un matériau renfermant des molécules gazeuses susceptibles d'être libérées sous l'effet d'un traitement thermique, et
- une couche de matériau getter recouvrant le composant électronique. électronique.

Le matériau getter recouvre intégralement le composant électronique. Toutefois, dans un exemple ne faisant pas partie de l'invention, il est possible que le matériau getter ne recouvre que partiellement le composant électronique. Dans ce cas, un deuxième getter peut être disposé dans la cavité afin de pomper les gaz relâchés au travers de la partie de la surface du composant électronique non recouverte par le matériau getter.

Le dispositif peut être de type MEMS, et/ou NEMS, et/ou MOEMS, et/ou NOEMS, et/ou un détecteur infrarouge, et/ou le composant électronique peut être un transistor de type MOS.

Le composant électronique peut faire partie d'un circuit intégré réalisé sur le premier substrat et dont au moins une partie est disposée sous la cavité.

La structure d'encapsulation peut comporter en outre une couche diélectrique disposée entre le composant électronique et la couche de matériau getter.

Cette couche diélectrique permet d'assurer une isolation électrique entre le composant électronique et la couche de matériau getter.

La cavité peut être formée entre le premier substrat et un second substrat solidarisé au premier substrat, ou entre le premier substrat et un capot comprenant une ou plusieurs couches minces solidarisées au premier substrat. Lorsque la cavité est formée entre le premier substrat et le second substrat, le scellement entre les deux substrats peut être assuré par un cordon de scellement, ou être obtenu par collage direct (collage moléculaire) ou scellement anodique directement entre les deux substrats. La cavité peut également être obtenue par la mise en oeuvre d'un procédé d'encapsulation de type PCM.

Dans un mode de réalisation particulier, le dispositif peut être réalisé sur le second substrat.

Dans ce cas, le dispositif et le composant électronique peuvent être disposés l'un en face de l'autre dans la cavité, sans être en contact l'un avec l'autre. Dans ce cas, le matériau getter couvre de préférence toute la surface du premier substrat exposée à l'intérieur de la cavité.

Dans un autre mode de réalisation particulier, le dispositif peut être réalisé sur, ou au-dessus de, la couche de matériau getter. Une telle configuration permet de superposer le dispositif sur le circuit intégré, et cela sans perturber le fonctionnement du dispositif. Une telle configuration permet également de relier électriquement, de manière aisée, le composant électronique au dispositif compte tenu de la proximité de ces deux éléments.

Le dispositif peut également être disposé sur le premier substrat et sur le deuxième substrat. Un dispositif peut également être réalisé sur chacun des substrats.

La structure d'encapsulation peut comporter en outre au moins une couche de passivation disposée entre la couche de matériau getter et le dispositif.

Une telle couche de passivation peut assurer une isolation électrique entre la couche de matériau getter et le dispositif.

La structure d'encapsulation peut comporter en outre au moins une première liaison électrique reliant électriquement le dispositif au composant électronique à travers la couche de matériau getter, et au moins une deuxième liaison électrique reliant électriquement le composant électronique à au moins un contact électrique disposé en dehors de la cavité (formant un ou plusieurs contacts électriques en face avant), la première et la deuxième liaisons électriques pouvant être isolées électriquement de la couche de matériau getter.

La structure d'encapsulation peut comporter en outre au moins une portion de matériau getter distincte de la couche de matériau getter et disposée dans la cavité. Cette portion de matériau getter peut ainsi contribuer au contrôle de l'atmosphère régnant dans la cavité, et notamment contribuer à obtenir le niveau de vide requis pour le fonctionnement du dispositif.

La structure d'encapsulation peut comporter en outre une ou plusieurs liaisons électriques traversant le premier substrat et reliant électriquement le composant électronique à un ou plusieurs contacts électriques (correspondant par exemple des contacts électriques en face arrière) disposés en dehors de la cavité, par exemple sur une face arrière du premier substrat. On peut ainsi réaliser une reprise de contacts électriques du composant électronique via la face arrière du premier substrat.

La couche de matériau getter peut comporter un empilement formé d'au moins une première couche composée de titane et recouvrant le composant électronique, d'une deuxième couche composée de nickel et recouvrant la première couche, et d'une troisième couche composée de titane et recouvrant la deuxième couche.

L'invention concerne également un procédé d'encapsulation d'au moins un dispositif et d'au moins un composant électronique dans une cavité, comportant au moins les étapes de :
- réalisation du composant électronique sur un premier substrat ;
- réalisation d'au moins une couche de matériau getter recouvrant le composant électronique ;
- réalisation du dispositif;
- fermeture hermétique de la cavité telle que le composant électronique et le dispositif soient encapsulés dans la cavité.

Le composant électronique peut comporter au moins un matériau obtenu par la mise en oeuvre d'un dépôt par exemple de type CVD ou par pulvérisation cathodique.

Le composant électronique peut comporter au moins un matériau renfermant des molécules gazeuses susceptibles d'être libérées sous l'effet d'un traitement thermique, c'est-à-dire d'une augmentation de température.

Le procédé de l'invention permet donc de former une cavité sous atmosphère contrôlée entre un support et un capot, cette cavité comportant au moins un dispositif formant un élément actif, le support et/ou le capot comportant au moins un composant électronique pouvant faire partie d'un circuit intégré électronique et exposé à l'intérieur de la cavité, ce procédé consistant à réaliser au moins un dépôt de matériau getter sur le capot et/ou le support afin de recouvrir le composant électronique, préalablement à la réalisation du dispositif et/ou avant la fermeture hermétique de la cavité.

La couche de matériau getter est donc déposée directement sur un substrat plan et peut-être mise en forme par des opérations classiques de photolithographie et gravure.

L'étape de fermeture hermétique de la cavité peut comporter la solidarisation d'un second substrat au premier substrat, ou la réalisation d'un capot comprenant une ou plusieurs couches minces solidarisées au premier substrat.

Le dispositif peut être réalisé sur le second substrat.

De manière alternative, le dispositif peut être réalisé sur, ou au-dessus de la couche de matériau getter.

Le procédé d'encapsulation peut comporter en outre, entre l'étape de réalisation de la couche de matériau getter et l'étape de réalisation du dispositif, une étape de réalisation d'au moins une couche de passivation sur la couche de matériau getter, le dispositif pouvant être réalisé sur la couche de passivation.

Le procédé d'encapsulation peut comporter en outre, avant la fermeture hermétique de la cavité, la réalisation d'au moins une première liaison électrique reliant électriquement le dispositif au composant électronique à travers la couche de matériau getter, et d'au moins une deuxième liaison électrique reliant électriquement le composant électronique à au moins un contact électrique disposé en dehors de la cavité, la première et la deuxième liaisons électriques pouvant être isolées électriquement de la couche de matériau getter.

Le procédé d'encapsulation peut comporter en outre, avant la fermeture hermétique de la cavité, la réalisation d'au moins une portion de matériau getter distincte de la couche de matériau getter et disposée dans la cavité.

Le procédé d'encapsulation peut comporter en outre la réalisation d'une ou plusieurs liaisons électriques traversant le premier substrat et reliant électriquement le composant électronique à un ou plusieurs contacts électriques disposés en dehors de la cavité, par exemple sur une face arrière du premier substrat.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1 à 3 et 5 à 7 représentent plusieurs structures d'encapsulation, objets de la présente invention, selon différents modes de réalisation ;
- les figures 4A et 4B représentent différentes reprises de contacts réalisables sur le premier substrat de la structure d'encapsulation selon la présente invention.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

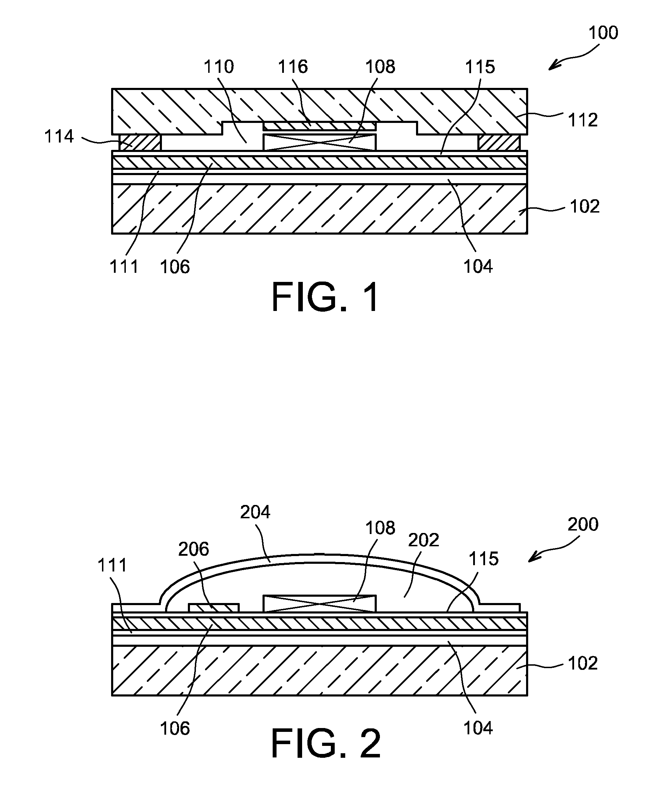

On se réfère tout d'abord à la figure 1 qui représente une structure d'encapsulation 100 selon un premier mode de réalisation.

La structure 100 comporte un premier substrat 102 sur lequel est réalisé un circuit intégré 104 représenté sur la figure 1 de manière schématique sous la forme d'une couche active disposée sur le premier substrat 102. Le circuit intégré 104 comporte notamment des dispositifs de type MOS tels que des transistors CMOS. Le circuit intégré 104 est recouvert d'une couche diélectrique 111 recouvrant notamment des plots de contact électrique du circuit intégré 104 et permettant d'isoler électriquement le circuit intégré 104 des éléments de la structure 100 destinés à être réalisés sur le circuit intégré 104.

Le circuit intégré 104 et la couche diélectrique 111 sont recouverts d'une couche de matériau getter 106, composée d'au moins un matériau getter apte à réaliser une absorption et/ou une adsorption gazeuse, avantageusement du titane, ou du zirconium, ou un alliage composé de titane et de zirconium. La couche de matériau getter 106 peut également servir à former une barrière vis-à-vis des gaz rares susceptibles d'être relâchés par le circuit intégré 104. L'épaisseur de la couche de matériau getter 106 est par exemple comprise entre quelques dizaines de nanomètres et quelques micromètres (par exemple inférieure à 10 µm). Il est possible que la couche de matériau getter 106 corresponde à un multicouche, comportant une ou plusieurs couches de matériaux getter superposées les unes sur les autres, et pouvant comportant une sous-couche permettant d'ajuster la température d'activation thermique du ou des matériaux getter disposés sur cette sous-couche d'ajustement. Un tel multicouche est par exemple décrit dans le document US 2010/178419 A1.

La couche de matériau getter 106 est avantageusement réalisée sous la forme d'un empilement de couches de type Ti/Ni/Ti permettant notamment de piéger efficacement des molécules d'hydrogène pouvant être relâchées par les composants électroniques du circuit intégré 104. En effet, avec un tel multicouche, la première couche composée de titane se trouvant du côté du circuit intégré 104 est apte à piéger des gaz, tels que du dioxygène, pouvant être libérés par le circuit intégré 104, et apte à bloquer des gaz rares (par exemple de l'argon et/ou du krypton) pouvant également être libérés par le circuit intégré 104. La deuxième couche composée de nickel permet de laisser passer des molécules d'hydrogène pouvant être libérées par le circuit intégré 104, ces molécules pouvant être ensuite absorbées par la troisième couche de titane réalisée de préférence avec une épaisseur supérieure à celle de la première couche de titane. La deuxième couche de nickel sert de « filtre » en laissant passer uniquement les molécules d'hydrogène, protégeant ainsi la troisième couche de titane des autres espèces gazeuses.

Il est également possible que la couche de matériau getter 106 comporte du palladium, ce qui permet d'absorber efficacement des molécules d'hydrogène.

Un dispositif 108, par exemple un micro-dispositif de type MEMS, est réalisé sur la couche de matériau getter 106. Ce dispositif 108 est encapsulé dans une cavité 110 formée entre le premier substrat 102 et un second substrat 112 solidarisé au premier substrat 102 par l'intermédiaire d'un cordon de scellement 114 par exemple composé d'au moins un matériau fusible.

Enfin, une partie de la face du second substrat 112 se trouvant à l'intérieur de la cavité 110 et formant une paroi supérieure de la cavité 110 est recouverte par une autre portion de matériau getter 116.

La structure d'encapsulation 100 comporte donc un dispositif 108 encapsulé dans une cavité 110, au moins une partie du circuit intégré 104 étant exposée dans la cavité 110. Lors de l'activation thermique de la couche de matériau getter 106 et de la portion de matériau getter 116, grâce au fait que la couche de matériau getter 106 recouvre au moins la partie du circuit intégré 104 se trouvant dans la cavité 110, les gaz piégés dans le circuit intégré 104 qui sont libérés par celui-ci lors de cette activation thermique sont donc bloqués et/ou capturés par la couche de matériau getter 106 qui recouvre le circuit intégré 104. La structure d'encapsulation 100 est avantageusement réalisée telle que la totalité de la surface du circuit intégré 104 se trouvant dans la cavité 110 soit recouverte par la couche de matériau getter 106.

Etant donné que la couche de matériau getter 106 est destinée à absorber et/ou adsorber des gaz libérés par sa face interne, c'est-à-dire sa face se trouvant en regard du circuit intégré 104, la microstructure de la couche de matériau getter 106 a moins d'influence sur les capacités d'absorption et/ou d'adsorption gazeuse du matériau getter que dans le cas d'une portion ou couche de matériau getter destinée à absorber et/ou adsorber des gaz par sa surface externe (surface exposée à l'atmosphère de la cavité, comme c'est le cas pour la portion de matériau getter 116).

En effet, lorsqu'un matériau getter est destiné à absorber et/ou adsorber des gaz par sa surface externe, l'effet getter est obtenu quand le matériau getter présente une structure colonnaire à petits grains, dont le diamètre est par exemple de l'ordre de quelques dizaines de nanomètres (par exemple entre environ 20 et 90 nm), facilitant ainsi la diffusion des espèces aux joints de grains et donc la capture des gaz à basse température, typiquement entre environ 200°C et 450°C. Au contraire, dans le cas de la couche de matériau getter 106, l'effet getter (absorption et/ou adsorption gazeuse) peut être obtenu même si la microstructure du matériau getter présente des grains plus gros, dont le diamètre est par exemple de l'ordre de quelques centaines de nanomètres (par exemple entre environ 100 nm et 900 nm). La couche de matériau getter 106 recouvrant le circuit intégré 104 peut donc être réalisée par un dépôt de type PVD, par exemple par pulvérisation cathodique ou évaporation. De plus, ce matériau getter peut être composé d'un seul matériau, tel que du titane, du zirconium ou tout autre métal présentant une capacité d'absorption/d'adsorption gazeuse, notamment vis-à-vis de l'hydrogène, ou susceptible de former des hydrures métalliques suffisamment stables en température.

De manière optionnelle, et comme représenté sur la figure 1, il est possible de recouvrir la couche de matériau getter 106 par une couche de passivation diélectrique 115 avant la réalisation du dispositif 108 afin d'isoler électriquement le dispositif 108 vis-à-vis de la couche de matériau getter 106. Cette couche de passivation 115 a par exemple une épaisseur comprise entre quelques dizaines de nanomètres et quelques microns (épaisseur par exemple inférieure à environ 10 µm). Outre son rôle d'isolant électrique, la couche de passivation 115 permet également de bloquer la diffusion de l'hydrogène pouvant être libéré par le circuit intégré 104, cette fonction de blocage de molécules gazeuses étant obtenue lorsque l'épaisseur de la couche de passivation 115 est supérieure à quelques nanomètres.

La couche 115 pourrait correspondre à une couche de passivation de la couche de matériau getter 106, c'est-à-dire être composée par exemple de TiO₂ pour un getter composé de titane, ou de ZrO₂ pour un getter composé de zirconium, sur laquelle on dépose avantageusement une couche d'isolation électrique par exemple composée de SiO₂.

Sur l'exemple de la figure 1, le circuit intégré 104 occupe toute la surface du premier substrat 102 se trouvant dans la cavité 110. Il est toutefois possible que le circuit intégré 104 n'occupe qu'une partie de la surface du substrat 102 se trouvant dans la cavité 110. Dans ce cas, la couche de matériau getter 106 recouvrant, directement ou non, le circuit intégré 104 peut être mise en forme par des opérations de photolithographie et de gravure telles qu'elle recouvre uniquement le circuit intégré 104, ou le circuit intégré 104 et une partie du substrat 102 non recouverte par le circuit intégré 104.

La figure 2 représente une structure d'encapsulation 200 selon un deuxième mode de réalisation.

Comme la structure d'encapsulation 100 précédemment décrite, la structure d'encapsulation 200 comporte le premier substrat 102, le circuit intégré 104 recouvert de la couche diélectrique 111, la couche de matériau getter 106 recouvrant la couche diélectrique 111, ainsi que le dispositif 108. Comme précédemment, une couche diélectrique 115 peut recouvrir la couche de matériau getter 106 afin d'isoler électriquement le dispositif 108 vis-à-vis de la couche de matériau getter 106.

Contrairement à la structure d'encapsulation 100 comportant un capot formé par le second substrat 112 solidarisé au premier substrat 102, la structure d'encapsulation 200 comporte une cavité 202 dans laquelle sont encapsulés le dispositif 108 et le circuit intégré 104, et formée entre le premier substrat 102 et une ou plusieurs couches minces 204 réalisées par un procédé de type PCM (comprenant notamment la réalisation d'une portion de matériau sacrificiel permettant de réaliser le dépôt de la ou des couches destinées à former le capot). La structure d'encapsulation 200 comporte également une ou plusieurs portions de matériau getter 206 disposées dans la cavité 202, sur la couche de passivation 115 (ou directement sur la couche de matériau getter 106 si cette couche de passivation 115 est absente), à côté du dispositif 108.

Dans une variante de ce deuxième mode de réalisation, lorsque le capot 204 est formé par une superposition d'au moins deux couches minces, la couche formant la paroi intérieure de la cavité 202 peut être composée d'au moins un matériau getter. Dans ce cas, il est possible de ne pas réaliser de portions de matériau getter 206 à côté du dispositif 108 et d'obtenir tout de même l'atmosphère souhaitée dans la cavité 202 permettant d'obtenir un bon fonctionnement du dispositif 108.

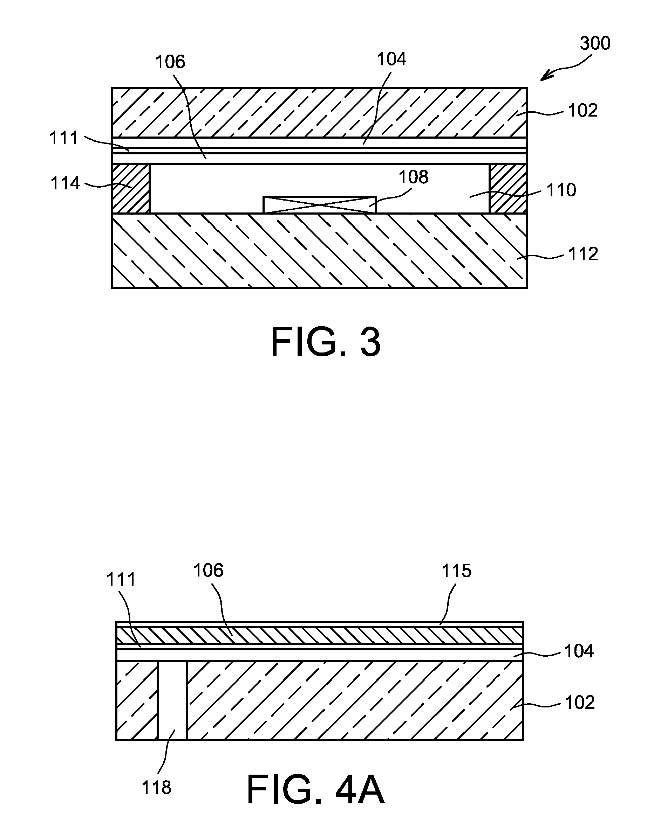

On se réfère à la figure 3 qui représente une structure d'encapsulation 300 selon un troisième mode de réalisation.

Comme la structure d'encapsulation 100, la structure d'encapsulation 300 comporte la cavité 110 formée entre le premier substrat 102 et le deuxième substrat 112 et dans laquelle sont encapsulés le dispositif 108 et au moins une partie du circuit intégré 104. Toutefois, dans ce troisième mode de réalisation, le circuit intégré 104 est réalisé sur le premier substrat 102 qui forme le capot de la cavité 110. Le dispositif 108 n'est donc pas réalisé sur le circuit intégré 104, mais directement sur et/ou dans le second substrat 112. Comme dans les précédents modes de réalisation, le circuit intégré 104 est recouvert par la couche de matériau getter 106 permettant d'absorber et/ou d'adsorber les gaz libérés par les matériaux du circuit intégré 104 lors de l'activation thermique du matériau getter présent dans la structure d'encapsulation 300. Bien que non représenté, il est possible qu'une ou plusieurs portions de matériau getter, par exemple similaires à la portion 206 précédemment décrite, soient réalisées sur le second substrat 112, à côté du dispositif 108, ou sur le premier substrat 102, contre la couche de matériau getter 106. Il est également possible qu'une autre couche de matériau getter soit réalisée sur le second substrat 112, le dispositif 108 étant réalisé sur cette autre couche de matériau getter. Cette autre couche de matériau getter peut être isolée électriquement du dispositif 108 par une couche diélectrique par exemple analogue à la couche de passivation 115.

Le premier et le troisième mode de réalisation peuvent être combinés tels qu'une structure d'encapsulation comporte le premier substrat 102 sur lequel sont réalisés le circuit intégré 104 et le dispositif 108 comme représenté sur la figure 1, et comporte également un deuxième substrat, formant le capot, sur lequel est également réalisé un autre circuit intégré recouvert d'une couche de matériau getter.

Bien que les structures d'encapsulation 100 et 200 aient été précédemment décrites comme encapsulant un seul dispositif 108, plusieurs dispositifs peuvent être encapsulés dans chacune des cavités 110 et 202 des structures d'encapsulation 100 et 200. Toutefois, les structures d'encapsulation 100 et 200 sont de préférence réalisées telles qu'elles encapsulent individuellement des dispositifs dans plusieurs cavités réalisées collectivement entre le premier substrat 102 et le deuxième substrat 112, et/ou entre le premier substrat 102 et des capots similaires au capot 204.

On décrit maintenant un exemple de procédé de réalisation de la structure d'encapsulation 100, c'est-à-dire un premier exemple de procédé d'encapsulation du dispositif 108.

On réalise tout d'abord le circuit intégré 104 sur le premier substrat 102 par la mise en oeuvre d'étapes classiques de micro-électronique. Le circuit intégré 104 est ensuite recouvert de la couche diélectrique 111 permettant notamment d'isoler électriquement le circuit intégré 104 de la couche de matériau getter 106 qui sera ensuite réalisée.

La couche, ou l'empilement de couches, de matériau getter 106 est ensuite réalisée telle qu'elle recouvre, totalement ou partiellement, le circuit intégré 104.

Une couche de passivation diélectrique 115, par exemple composée d'oxyde et/ou de nitrure de semi-conducteur (par exemple du silicium), peut ensuite être réalisée sur la couche de matériau getter 106. Le ou les matériaux de cette couche de passivation 115 sont choisis de préférence tels qu'ils soient le moins propice au dégazage après leurs réalisations et lorsqu'ils sont soumis à un traitement thermique.

Cette couche de passivation 115 est par exemple composée de SiO₂ déposé par évaporation (étape pouvant être enchaînée après le dépôt de la couche de matériau getter 106 dans un même équipement de dépôt).

La couche de passivation 115 peut également être réalisée par la mise en oeuvre d'une oxydation et/ou une nitruration contrôlée par voie sèche du matériau getter de la couche 106, provoquant ainsi la croissance de cet oxyde et/ou de ce nitrure. Une telle oxydation et/ou nitruration peut être réalisée à une température comprise entre environ 150°C et 250°C, sous atmosphère sèche de dioxygène et/ou de diazote, à une pression supérieure ou égale à environ 10⁻³ mbar pendant quelques minutes. La couche de passivation 115 obtenue correspond alors à une couche d'oxyde métallique dont les caractéristiques électriques lui confèrent à la fois un rôle de barrière de diffusion à l'hydrogène et un rôle d'isolant électrique par rapport au circuit intégré 104. Cette isolation électrique est avantageusement renforcée par un dépôt d'isolant tel que du SiO₂.

De manière avantageuse, on réalise ensuite un traitement thermique, par exemple à une température comprise entre environ 300°C et 450°C, avantageusement sous vide secondaire, pendant une durée comprise entre quelques minutes et environ 1 heure. Un tel traitement thermique permet à la couche de matériau getter 106 de piéger les gaz venant du circuit intégré 104. En effet, sous l'action de la température, le matériau getter s'active alors que les gaz piégés s'échappent vers l'extérieur du circuit intégré 104. Il permet aussi de dégazer la couche de passivation 115. Le substrat est ainsi prêt pour des étapes technologiques ultérieures.

Ce traitement thermique permet donc de stabiliser, vis-à-vis de sa propension à dégazer, l'empilement comprenant la couche de matériau getter 106 et la couche de passivation 115.

On réalise ensuite une reprise de contacts électriques sur le circuit intégré 104. Cette reprise de contacts peut être réalisée par la face arrière du circuit intégré 104, c'est-à-dire la face du circuit intégré 104 se trouvant contre le substrat 102. Ainsi, comme représenté sur la figure 4A, un ou plusieurs vias 118 sont réalisés à travers le substrat 102, formant un ou plusieurs accès à la face arrière du circuit intégré 104. Un matériau électriquement conducteur est ensuite déposé dans ce ou ces vias pour former une ou plusieurs liaisons électriques reliées électriquement au circuit intégré 104.

Le dispositif 108 est ensuite réalisé sur la couche de passivation 115, par la mise en oeuvre d'étapes de dépôt, photolithographie et gravure.

La cavité 110 est ensuite fermée en solidarisant le second substrat 112 au premier substrat 102, la portion de matériau getter 116 étant au préalable réalisée contre le second substrat 112.

Par rapport à la réalisation de la structure d'encapsulation 100, la réalisation de la structure d'encapsulation 200 comporte la réalisation de la portion de matériau getter 206 sur la couche de passivation 115, à côté du dispositif 108. La cavité 202 est fermée en recouvrant le dispositif 108 et la portion de matériau getter 206 par une couche de matériau sacrificiel qui est ensuite gravée telle qu'une portion restante de matériau sacrificiel corresponde au volume souhaité de la cavité 202. La portion de matériau sacrificiel est ensuite recouverte d'une ou plusieurs couches minces (dont celle se trouvant contre la portion de matériau sacrificiel peut être composée de matériau getter), formant le capot 204. La portion de matériau sacrificiel est ensuite gravée via un trou de libération réalisé à travers le capot 204, le trou étant ensuite bouché.

La structure d'encapsulation 300 est obtenue en réalisant le dispositif 108 directement sur le premier substrat 102. Parallèlement, le circuit intégré 104 est réalisé sur le second substrat 112, le circuit intégré 104 étant ensuite recouvert par la couche de matériau getter 106 et éventuellement une couche de passivation. Les deux substrats 102 et 112 sont ensuite solidarisés l'un à l'autre afin de fermer la cavité 110. La reprise de contacts électriques est réalisée à travers le second substrat 112.

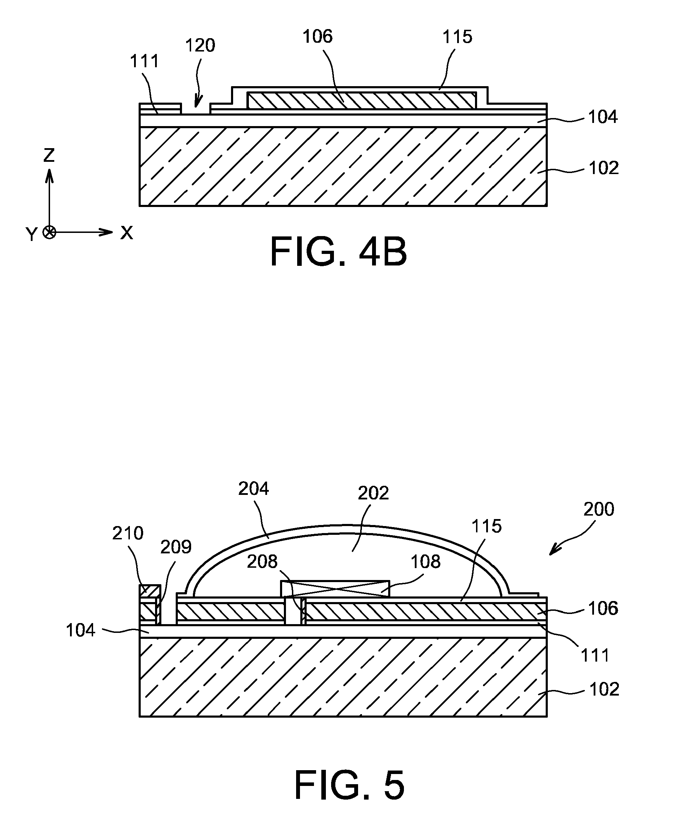

En variante, quelque soit la structure d'encapsulation considérée, il est possible de réaliser une reprise de contacts électriques au niveau d'une face avant du circuit intégré 104, c'est-à-dire au niveau de la face du circuit intégré 104 se trouvant du côté de la cavité. Dans ce cas, après avoir réalisé le circuit intégré 104 recouvert de la couche de matériau getter 106, cette dernière peut être gravée telle qu'une portion restante de matériau getter 106 recouvre la partie du circuit intégré 104 destinée à être encapsulée dans la cavité avec le dispositif 108. La portion restante de la couche de matériau getter 106 peut ensuite être recouverte par la couche de passivation 115, qui recouvre également une ou plusieurs parties du circuit intégré 104 qui ne sont pas destinées à être exposées dans la cavité. Ainsi, il est possible de réaliser un ou plusieurs contacts électriques en gravant un ou plusieurs accès 120 au circuit intégré 104 au niveau de zones de contact du circuit intégré 104 destinées à se trouver en dehors de la cavité, à travers la couche de passivation 115 et éventuellement la couche diélectrique 111 (voir Figure 4B). Ces accès 120 sont ensuite métallisés afin de former des contacts reliés électriquement au circuit intégré 104. Une telle reprise de contact est avantageusement réalisée pour une encapsulation de type PCM (comme la structure d'encapsulation 200).

La figure 5 représente la structure d'encapsulation 200 selon une première variante de réalisation, dans laquelle la reprise de contacts électriques est réalisée au niveau de la face avant du circuit intégré 104. On voit sur cette figure que le circuit intégré 104 est relié électriquement au dispositif 108 par une première liaison électrique 208 qui traverse la couche de matériau getter 106, la couche de passivation 115 et la couche diélectrique 111. Une deuxième liaison électrique 209 permet de contacter électriquement le circuit intégré 104 depuis l'extérieur de la cavité 202, cette deuxième liaison 209 traversant la couche de passivation 115 pour déboucher sur la face avant de la structure d'encapsulation 200 et être reliée à un contact électrique 210 formé sur la face avant. Les liaisons électriques 208 et 209 sont isolées électriquement de la couche de matériau getter 106, par exemple en entourant le matériau électriquement conducteur de ces liaisons par un matériau diélectrique disposé au préalable dans les trous formés à travers la couche de matériau getter 106 et la couche de passivation 115.

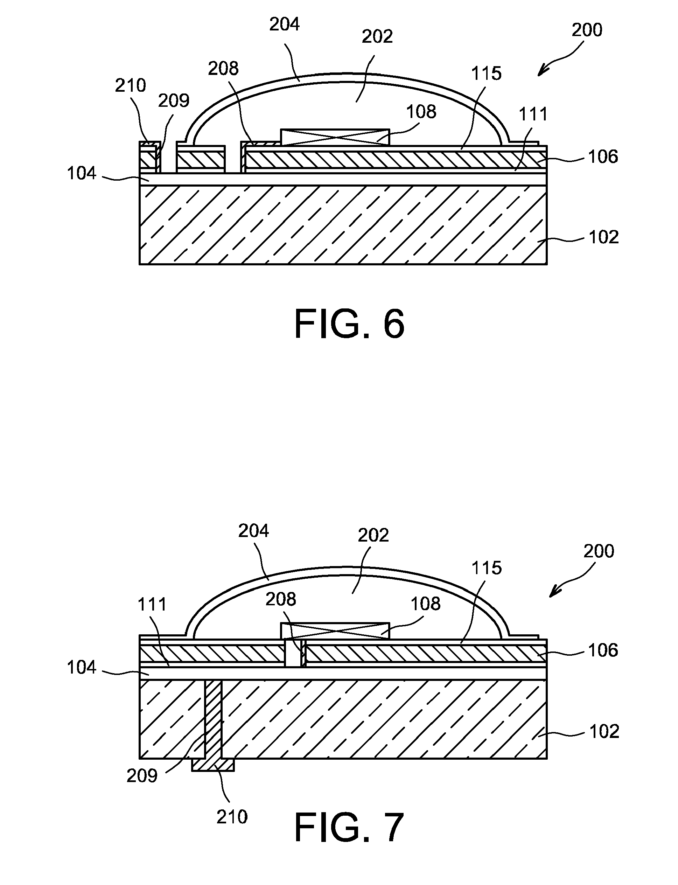

La figure 6 représente la structure d'encapsulation 200 selon une deuxième variante de réalisation. Par rapport à la première variante de réalisation représentée sur la figure 5, la liaison électrique 208 est située à côté du dispositif 108 et comporte deux parties perpendiculaire l'une par rapport à l'autre, l'une étant dans le plan du dispositif 108, l'autre étant dans un plan perpendiculaire au dispositif 108 et traversant les couches 106, 111 et 115.

Dans une troisième variante représentée sur la figure 7, la deuxième liaison électrique 209 traverse le substrat 102 pour venir déboucher sur la face arrière du substrat 102 et être en contact avec un contact électrique 210 réalisé au niveau de la face arrière du substrat 102.

## Revendications

1. Structure d'encapsulation (100, 200, 300) comportant au moins une cavité (110, 202) formée entre un premier substrat (102) et un capot (112), la cavité étant fermée hermétiquement et dans laquelle sont encapsulés au moins :
- un dispositif (108),
- un composant électronique faisant partie d'un circuit intégré (104) réalisé sur le premier substrat (102), et
- une couche de matériau getter (106) recouvrant intégralement le composant électronique de façon à bloquer les gaz susceptibles d'être dégazés par le composant électronique,
le composant électronique, par conséquent, n'étant pas exposé dans la cavité
et dans laquelle le dispositif (108) n'est pas recouvert par la couche de matériau getter (106).

2. Structure d'encapsulation (100, 200, 300) selon la revendication 1, dans laquelle le dispositif (108) est de type MEMS, et/ou NEMS, et/ou MOEMS, et/ou NOEMS, et/ou un détecteur infrarouge, et/ou dans laquelle le composant électronique est un transistor de type MOS.

3. Structure d'encapsulation (100, 200, 300) selon l'une des revendications précédentes, dans laquelle le composant électronique fait partie d'un circuit intégré (104) réalisé sur le premier substrat (102) et dont au moins une partie est disposée sous la cavité (110, 202).

4. Structure d'encapsulation (100, 200, 300) selon l'une des revendications précédentes, comportant en outre une couche diélectrique (111) disposée entre le composant électronique et la couche de matériau getter (106).

5. Structure d'encapsulation (100, 200, 300) selon l'une des revendications précédentes, dans laquelle la cavité (110) est formée entre le premier substrat (102) et un second substrat (112) solidarisé au premier substrat (102), ou entre le premier substrat (102) et un capot (204) comprenant une ou plusieurs couches minces solidarisées au premier substrat (102).

6. Structure d'encapsulation (300) selon la revendication 5, dans laquelle le dispositif (108) est réalisé sur le second substrat (112).

7. Structure d'encapsulation (100, 200) selon l'une des revendications 1 à 6, dans laquelle le dispositif (108) est réalisé au-dessus de la couche de matériau getter (106).

8. Structure d'encapsulation (100, 200) selon la revendication 7, comportant en outre au moins une couche de passivation (115) disposée entre la couche de matériau getter (106) et le dispositif (108).

9. Structure d'encapsulation (200) selon l'une des revendications 7 ou 8, comportant en outre au moins une première liaison électrique (208) reliant électriquement le dispositif (108) au composant électronique à travers la couche de matériau getter (106), et au moins une deuxième liaison électrique (209) reliant électriquement le composant électronique, à au moins un contact électrique (210) disposé en dehors de la cavité (202), la première (208) et la deuxième (209) liaisons électriques étant isolées électriquement de la couche de matériau getter (106).

10. Structure d'encapsulation (100, 200) selon l'une des revendications précédentes, comportant en outre au moins une portion de matériau getter (116, 206) distincte de la couche de matériau getter (106) et disposée dans la cavité (110, 202).

11. Structure d'encapsulation (100, 200, 300) selon l'une des revendications précédentes, comportant en outre une ou plusieurs liaisons électriques (209) traversant le premier substrat (102) et reliant électriquement le composant électronique à un ou plusieurs contacts électriques (210) disposés en dehors de la cavité (110,202).

12. Structure d'encapsulation (100, 200, 300) selon l'une des revendications précédentes, dans laquelle la couche de matériau getter (106) comporte un empilement formé d'au moins une première couche composée de titane et recouvrant le composant électronique, d'une deuxième couche composée de nickel et recouvrant la première couche, et d'une troisième couche composée de titane et recouvrant la deuxième couche.

13. Procédé d'encapsulation d'au moins un dispositif (108) et d'au moins un composant électronique dans une cavité (110, 202), comportant au moins les étapes de :
- réalisation du composant électronique faisant partie d'un circuit intégré (104) sur un premier substrat (102) ;
- réalisation d'au moins une couche de matériau getter (106) recouvrant intégralement le composant électronique de façon à bloquer les gaz susceptibles d'être dégazés par le composant électronique,
- réalisation du dispositif (108),
- fermeture hermétique de la cavité (110, 202) par un capot (112) telle que le composant électronique et le dispositif (108) soient encapsulés dans la cavité (110, 202),
le composant électronique, par conséquent, n'étant pas exposé dans la cavité,
le dispositif (108) n'étant pas recouvert par la couche de matériau getter (106).

14. Procédé d'encapsulation selon la revendication 13, dans lequel l'étape de fermeture hermétique de la cavité (110, 202) comporte la solidarisation d'un second substrat (112) au premier substrat (102), ou la réalisation d'un capot (204) comprenant une ou plusieurs couches minces solidarisées au premier substrat (102).

15. Procédé d'encapsulation selon la revendication 14, dans lequel le dispositif (108) est réalisé sur le second substrat (112).

16. Procédé d'encapsulation selon l'une des revendications 13 ou 14, dans lequel le dispositif (108) est réalisé au-dessus de la couche de matériau getter (106).

17. Procédé d'encapsulation selon la revendication 16, comportant en outre, entre l'étape de réalisation de la couche de matériau getter (106) et l'étape de réalisation du dispositif (108), une étape de réalisation d'au moins une couche de passivation (115) sur la couche de matériau getter (106), le dispositif (108) étant réalisé sur la couche de passivation (115).

18. Procédé d'encapsulation selon l'une des revendications 16 ou 17, comportant en outre, avant la fermeture hermétique de la cavité (110, 202), la réalisation d'au moins une première liaison électrique (208) reliant électriquement le dispositif (108) au composant électronique à travers la couche de matériau getter (106), et d'au moins une deuxième liaison électrique (209) reliant électriquement le composant électronique à au moins un contact électrique (210) disposé en dehors de la cavité (110, 202), la première (208) et la deuxième (209) liaisons électriques étant isolées électriquement de la couche de matériau getter (106).

19. Procédé d'encapsulation selon l'une des revendications 13 à 18, comportant en outre, avant la fermeture hermétique de la cavité (110, 202), la réalisation d'au moins une portion de matériau getter (116, 206) distincte de la couche de matériau getter (106) et disposée dans la cavité (110, 202).

20. Procédé d'encapsulation selon l'une des revendications 13 à 19, comportant en outre la réalisation d'une ou plusieurs liaisons électriques (209) traversant le premier substrat (102) et reliant électriquement le composant électronique à un ou plusieurs contacts électriques (210) disposés en dehors de la cavité.

## Patentansprüche

1. Verkapselungsstruktur (100, 200, 300), umfassend wenigstens einen Hohlraum (110, 202), welcher zwischen einem ersten Substrat (102) und einer Abdeckung (112) gebildet ist, wobei der Hohlraum hermetisch abgeschlossen ist und wobei wenigstens verkapselt sind:
- eine Vorrichtung (108),
- eine zu einem integrierten Schaltkreis (104), welcher auf dem ersten Substrat (102) ausgebildet ist, zugehörige elektronische Komponente, und
- eine Schicht aus einem Getter-Material (106), welche die elektronische Komponente integral derart bedeckt, dass von der elektronischen Komponente ausgasbare Gase blockiert werden,
wobei folglich die elektronische Komponente nicht in dem Hohlraum offenliegt,
und wobei die Vorrichtung (108) nicht von der Schicht aus einem Getter-Material (106) bedeckt ist.

2. Verkapselungsstruktur (100, 200, 300) nach Anspruch 1, wobei die Vorrichtung (108) vom Typ eines MEMS oder/und NEMS oder/und MOEMS oder/und NOEMS oder/und eines Infrarot-Detektors ist oder/und wobei die elektronische Komponente ein Transistor vom MOS-Typ ist.

3. Verkapselungsstruktur (100, 200, 300) nach einem der vorhergehenden Ansprüche, wobei die elektronische Komponente zu einem integrierten Schaltkreis (104), welcher auf dem ersten Substrat (102) gebildet ist, zugehörig ist und wenigstens ein Teil von ihr unter dem Hohlraum (110, 202) angeordnet ist.

4. Verkapselungsstruktur (100, 200, 300) nach einem der vorhergehenden Ansprüche, ferner umfassend eine dielektrische Schicht (111), welche zwischen der elektronischen Komponente und der Schicht aus einem Getter-Material (106) angeordnet ist.

5. Verkapselungsstruktur (100, 200, 300) nach einem der vorhergehenden Ansprüche, wobei der Hohlraum (110) zwischen dem ersten Substrat (102) und einem zweiten Substrat (112) gebildet ist, welches mit dem ersten Substrat (102) verbunden ist, oder zwischen dem ersten Substrat (102) und einer Abdeckung (204), welche eine oder mehrere dünne Schichten umfasst, welche mit dem ersten Substrat (102) verbunden sind.

6. Verkapselungsstruktur (300) nach Anspruch 5, wobei die Vorrichtung (108) auf dem zweiten Substrat (112) ausgebildet ist.

7. Verkapselungsstruktur (100, 200) nach einem der Ansprüche 1 bis 6, wobei die Vorrichtung (108) oberhalb der Schicht aus einem Getter-Material (106) ausgebildet ist.

8. Verkapselungsstruktur (100, 200) nach Anspruch 7, ferner umfassend wenigstens eine Passivierungs-Schicht (115), welche zwischen der Schicht aus einem Getter-Material (106) und der Vorrichtung (108) angeordnet ist.

9. Verkapselungsstruktur (200) nach einem der Ansprüche 7 oder 8, ferner umfassend wenigstens eine elektrische Verbindung (208), welche die Vorrichtung (108) mit der elektronischen Komponente durch die Schicht aus einem Getter-Material (106) hindurch elektrisch verbindet, sowie wenigstens eine zweite elektrische Verbindung (209), welche die elektronische Komponente mit wenigstens einem außerhalb des Hohlraums (202) angeordneten elektrischen Kontakt (210) verbindet, wobei die erste (208) und die zweite (209) elektrische Verbindung von der Schicht aus einem Getter-Material (106) elektrisch isoliert sind.

10. Verkapselungsstruktur (100, 200) nach einem der vorhergehenden Ansprüche, ferner umfassend wenigstens einen von der Schicht aus einem Getter-Material (106) verschiedenen Abschnitt eines Getter-Materials (116, 206), welcher in dem Hohlraum (110, 202) angeordnet ist.

11. Verkapselungsstruktur (100, 200, 300) nach einem der vorhergehenden Ansprüche, ferner umfassend eine oder mehrere elektrische Verbindungen (209), welche durch das erste Substrat (102) hindurch verlaufen und die elektronische Komponente mit einem oder mehreren elektrischen Kontakten (210) verbinden, welche außerhalb des Hohlraums (110, 202) angeordnet sind.

12. Verkapselungsstruktur (100, 200, 300) nach einem der vorhergehenden Ansprüche, wobei die Schicht aus einem Getter-Material (106) einen Stapel umfasst, welcher aus wenigstens einer ersten Schicht, welche aus Titan besteht und die elektronische Komponente bedeckt, einer zweiten Schicht, welche aus Nickel besteht und die erste Schicht bedeckt, und einer dritten Schicht gebildet ist, welche aus Titan besteht und die zweite Schicht bedeckt.

13. Verfahren zum Verkapseln wenigstens einer Vorrichtung (108) und wenigstens einer elektronischen Komponente in einem Hohlraum (110, 202), umfassend wenigstens die Schritte:
- Ausbilden der einem integrierten Schaltkreis (104) zugeordneten elektronischen Komponente auf einem ersten Substrat (102);
- Ausbilden wenigstens einer Schicht aus einem Getter-Material (106), welches die elektronische Komponente derart bedeckt, dass von der elektronischen Komponente ausgasbare Gase blockiert werden,
- Ausbilden der Vorrichtung (108),
- Hermetisches Schließen des Hohlraums (110, 202) durch eine Abdeckung (112), so dass die elektronische Komponente und die Vorrichtung (108) in dem Hohlraum (110, 202) verkapselt werden,
wobei die elektronische Komponente folglich nicht in dem Hohlraum offenliegt,
wobei die Vorrichtung (108) nicht von der Schicht aus einem Getter-Material (106) bedeckt wird.

14. Verfahren zum Verkapseln nach Anspruch 13, wobei der Schritt des hermetischen Schließens des Hohlraums (110, 202) das Verbinden eines zweiten Substrats (112) mit dem ersten Substrat (102) umfasst, oder das Ausbilden einer Abdeckung (204), welche eine oder mehrere mit dem ersten Substrat (102) verbundene dünne Schichten umfasst.

15. Verfahren zum Verkapseln nach Anspruch 14, wobei die Vorrichtung (108) auf dem zweiten Substrat (112) ausgebildet ist.

16. Verfahren zum Verkapseln nach einem der Ansprüche 13 oder 14, wobei die Vorrichtung (108) oberhalb der Schicht aus einem Getter-Material (106) ausgebildet ist.

17. Verfahren zum Verkapseln nach Anspruch 16, ferner umfassend, zwischen dem Schritt des Ausbildens der Schicht aus einem Getter-Material (106) und dem Schritt des Ausbildens der Vorrichtung (108), einen Schritt eines Ausbildens von wenigstens einer Passivierungs-Schicht (115) auf der Schicht aus einem Getter-Material (106), wobei die Vorrichtung (108) auf der Passivierungs-Schicht (115) ausgebildet wird.

18. Verfahren zum Verkapseln nach einem der Schritte 16 oder 17, ferner umfassend, vor dem hermetischen Schließen des Hohlraums (110, 202), das Ausbilden von wenigstens einer ersten elektrischen Verbindung (208), welche die Vorrichtung (108) mit der elektronischen Komponente durch die Schicht aus einem Getter-Material (106) hindurch verbindet, sowie wenigstens einer zweiten elektrischen Verbindung (209), welche die elektronische Komponente mit wenigstens einem elektrischen Kontakt verbindet, welcher außerhalb des Hohlraums (110, 202) angeordnet ist, wobei die erste (208) und zweite (209) elektrische Verbindung von der Schicht aus einem Getter-Material (106) elektrisch isoliert ist.

19. Verfahren zum Verkapseln nach einem der Ansprüche 13 bis 18, ferner umfassend, vor dem hermetischen Schließen des Hohlraums (110, 202), das Ausbilden wenigstens eines von der Schicht aus einem Getter-Material (106) verschiedenen Abschnitts eines Getter-Materials (116, 206), welcher in dem Hohlraum (110, 202) angeordnet ist.

20. Verfahren zum Verkapseln nach einem der Ansprüche 13 bis 19, ferner umfassend das Ausbilden von einer oder mehreren elektrischen Verbindungen (209), welche durch das erste Substrat (102) hindurchtreten und die elektronische Komponente mit einem oder mehreren elektrischen Kontakten (210) verbinden, welche außerhalb des Hohlraums angeordnet sind.

## Claims

1. Encapsulation structure (100, 200, 300) comprising at least one cavity (110, 202) formed between a first substrate (102) and a cap (112), the cavity being hermetically sealed and in which at least the following are encapsulated:
- a device (108),
- an electronic component forming part of an integrated circuit (104) made on the first substrate (102), and
- a getter material layer (106) covering the electronic component in full in order to block the gases capable of being degassed by the electronic component,
the electronic component being thus not exposed in the cavity, and in which the device (108) is not covered by the getter material layer (106).

2. Encapsulation structure (100, 200, 300) according to claim 1, wherein the device (108) is of the MEMS, and/or NEMS, and/or MOEMS, and/or NOEMS type, and/or an infrared sensor, and/or the electronic component is an MOS-type transistor.

3. Encapsulation structure (100, 200, 300) according to one of preceding claims, wherein the electronic component is part of an integrated circuit (104) made on the first substrate (102) and of which at least a part is arranged under the cavity (110,202).

4. Encapsulation structure (100, 200, 300) according to one of preceding claims, also comprising a dielectric layer (111) arranged between the electronic component and the getter material layer (106).

5. Encapsulation structure (100, 200, 300) according to one of preceding claims, wherein the cavity (110) is formed between the first substrate (102) and a second substrate (112) secured to the first substrate (102), or between the first substrate (102) and a cap (204) including one or more thin films secured to the first substrate (102).

6. Encapsulation structure (300) according to claim 5, wherein the device (108) is produced on the second substrate (112).

7. Encapsulation structure (100, 200) according to one of claims 1 to 6, wherein the device (108) is made over the getter material layer (106).

8. Encapsulation structure (100, 200) according to claim 7, also comprising at least one passivation layer (115) arranged between the getter material layer (106) and the device (108).

9. Encapsulation structure (200) according to one of claims 7 or 8, also comprising at least one first electrical connection (208) electrically connecting the device (108) to the electronic component through the getter material layer (106), and at least one second electrical connection (209) electrically connecting the electronic component to at least one electrical contact (210) arranged outside of the cavity (202), with the first (208) and second (209) electrical connections being electrically insulated from the getter material layer (106).

10. Encapsulation structure (100, 200) according to one of preceding claims, also comprising at least one getter material portion (116, 206) distinct from the getter material layer (106) and arranged in the cavity (110, 202).

11. Encapsulation structure (100, 200, 300) according to one of preceding claims, also comprising one or more electrical connections (209) passing through the first substrate (102) and electrically connecting the electronic component to one or more electrical contacts (210) arranged outside of the cavity (110, 202).

12. Encapsulation structure (100, 200, 300) according to one of preceding claims, wherein the getter material layer (106) comprises a stack formed by at least one first layer comprising titanium and covering the electronic component, a second layer comprising nickel and covering the first layer, and a third layer comprising titanium and covering the second layer.

13. Process for encapsulating at least one device (108) and at least one electronic component in a cavity (110, 202), comprising at least the steps of:
- producing the electronic component forming part of an integrated circuit (104) on a first substrate (102);
- producing at least one getter material layer (106) covering the electronic component in full in order to block the gases capable of being degassed by the electronic component;
- producing the device (108);
- hermetically sealing the cavity (110, 202) by a cap (112) so that the electronic component and the device (108) are encapsulated in the cavity (110, 202),
the electronic component being thus not exposed in the cavity, the device (108) being not covered by the getter material layer (106).

14. Encapsulation process according to claim 13, wherein the step of hermetically sealing the cavity (110, 202) comprises the securing of a second substrate (112) to the first substrate (102), or the production of a cap (204) including one or more thin films secured to the first substrate (102).

15. Encapsulation process according to claim 14, wherein the device (108) is produced on the second substrate (112).

16. Encapsulation process according to one of claims 13 or 14, wherein the device (108) is produced over the getter material layer (106).

17. Encapsulation process according to claim 16, also comprising, between the step of producing the getter material layer (106) and the step of producing the device (108), a step of producing at least one passivation layer (115) on the getter material layer (106), with the device (108) being produced on the passivation layer (115).

18. Encapsulation process according to one of claims 16 or 17, also comprising, before the hermetic sealing of the cavity (110, 202), the production of at least one first electrical connection (208) electrically connecting the device (108) to the electronic component through the getter material layer (106), and at least one second electrical connection (209) electrically connecting the electronic component to at least one electrical contact (210) arranged outside the cavity (110, 202), with the first (208) and the second (209) electrical connections being electrically insulated from the getter material layer (106).

19. The encapsulation process according to one of claims 13 to 18, also comprising, before the hermetic sealing of the cavity (110, 202), the production of at least one getter material portion (116, 206) distinct from the getter material layer (106) and arranged in the cavity (110, 202).

20. The encapsulation process according to one of claims 13 to 19, also comprising the production of one or more electrical connections (209) passing through the first substrate (102) and electrically connecting the electronic component to one or more electrical contacts (210) arranged outside the cavity.
